Europäisches Patentamt

European Patent Office

Office européen des brevets

(19)

(11) Publication number: **0 222 144 B1**

# EUROPEAN PATENT SPECIFICATION

(12)

(45) Date of publication of patent specification: **25.03.92**

(51) Int. Cl.⁵: **H01L 23/52**, H01L 21/58, H01L 25/04

(21) Application number: **86113735.4**

(22) Date of filing: **03.10.86**

(54) A wafer-scale semiconductor device.

(30) Priority: **05.10.85 JP 222593/85**

(43) Date of publication of application:
**20.05.87 Bulletin 87/21**

(45) Publication of the grant of the patent:
**25.03.92 Bulletin 92/13**

(84) Designated Contracting States:
**DE FR GB**

(56) References cited:
**EP-A- 0 110 285**
**EP-A- 0 149 317**
**EP-A- 0 154 431**
**DE-A- 2 704 373**
**FR-A- 2 572 849**

**PATENTS ABSTRACTS OF JAPAN, vol. 8, no. 235 (E-275)[1672], 27th October 1984; & JP-A-59 117 250**

(73) Proprietor: **FUJITSU LIMITED**
**1015, Kamikodanaka Nakahara-ku**
**Kawasaki-shi Kanagawa 211(JP)**

(72) Inventor: **Fukushima, Toshitaka Fujitsu Ltd.**
**Patent Dep.**
**Kosugi Fujitsu Building 1812-10**
**Shimonumabe**
**Nakahara-ku Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

The present invention relates to a wafer-scale semiconductor device.

In order to meet the increasing demand for larger scales of integration of semiconductor devices, for achieving more functions, higher speed and smaller gross size, there have been proposed many methods of integration.

One method involves the use of a multi-chip module. IC (Integrated Circuit) chips are encapsulated in a so-called chip carrier, a package, having printed leads on the sides of the carrier. A plurality of chip-carriers having IC chips therein are mounted on a small ceramic mother board, a substrate, to constitute a module by means of conventional hybrid IC technology. A plurality of these modules are mounted on a big, main ceramic board. These multi-chip modules are now being used in practical applications. However, with this method, there are problems of cooling the IC chips and wiring the IC chips on the mother board.

The heat dissipated in the IC chips is removed by conduction through the ceramic substrate in a chip-carrier and through the ceramic substrate of the mother board, and finally by forced air flow or liquid flow, and some heat is also removed through the main ceramic board.

The amount of heat to be removed is now as much as $10W/cm^2$, in a modern system. This means that the heat resistance of the ceramic boards cannot be ignored.

Because of the requirement for high-density wiring, multi-layer ceramic boards are generally employed. The wirings in a multi-layer ceramic board are formed using refractory metal powders, such as molybdenum or tungsten, which, however, results in wirings of higher electrical resistance than other generally used wirings. High resistance of wirings, of course, has a detrimental effect on performance.

In addition to these problems, satisfactory accuracy of placing of the chip carriers cannot be achieved, because the structure of a chip carrier is not suitable for precise positioning. This means that the spacing of layer-wirings cannot be chosen small enough to achieve a desired high-density integration.

Another method which has been employed in an attempt to satisfy the demand for higher-scale integration involves a monolithic semiconductor fabrication technology.

The size of a monolithic IC chip is now as large as 5 or 6 inches in diameter, wafer-size, for example, with as many as more than several hundreds of thousands of gates integrated on the chip.

The scale of this integration is several tens to several hundreds times that of previous LSIs (Large-scale ICs). However, for this scale of integration, there are both technical and economic limits.

The yield (that is the probability that no defects exist in a chip) of larger integration scale ICs decreases generally in proportion to the nth power of the yield of lower integration scale ICs, where n is the ratio of the scale of the larger integration scale IC to the scale of lower integration scale IC. Therefore, as the scale of integration of a chip becomes larger, the production yield drastically decreases, potentially fatally increasing production cost.

In addition to this yield problem, the cost of masks for the relevant photo-lithography becomes extremely great, particularly when production is in relatively small quantities.

These facts indicate that wafer-scale integration is almost impossible to achieve in industrial application.

Therefore, there is still a desire for a means of achieving a well-designed very large-scale integration which does not suffer, or suffers to a lesser extent, the above-described technical problems, and which is subject to lesser cost problems.

An embodiment of the present invention can provide a high-performance multi-chip integrated circuit, equivalent to a wafer-scale integration, but of relatively low cost.

EP-A-0 110 285 discloses the mounting of electrical components, which may be unpackaged semiconductor chips, on an insulating substrate such that contact areas of the components lie in a substantially flat plane, with a conductive pattern deposited over the substrate to establish electrical connection between the components.

The components are preferably mounted on the insulating substrate by encapsulation, for example by casting in epoxy resin.

EP-A-0 149 317 discloses a circuit assembly including a laminar carrier, advantageously of a material thermally matched to semiconductor devices supported thereon, the surface of which is coated with a thick layer of insulating material, in which thick layer windows are etched and in which windows semiconductor devices are located. A further planarizing layer of insulating material is provided in which openings are formed to expose terminal regions of the semiconductor devices. Metallization and, perhaps, a further insulating layer is provided. Bonding pads, for external connection of circuitry, are provided on the metallization.

According to the present invention, there is provided a wafer-scale semiconductor integrated circuit device, comprising:-

(a) a plurality of integrated circuit chips;

(b) a substrate on which the chips are mounted, each with its wired surface upwards;

(c) binder material, of essentially the same material as the material of the chips, having essentially the same thermal expansion coefficient as the thermal expansion coefficient of the chips, filling the gaps between the chips, whereby the chips are bound to the substrate and to each other;

(d) an electrically insulating layer formed upon the wired surfaces of the chips and upon the binder material in the filled gaps, excluding portions where terminal pads of the chips are located;

(e) electrically conductive layer-wiring formed upon the insulating layer for operatively interconnecting the chip terminal pads; and

(f) one or more device terminal pads, for connecting the device to external circuitry, provided in connection with the electrically conductive layer-wiring.

According to the present invention, there is provided a wafer-scale semiconductor integrated circuit device comprising:-

(a) a plurality of integrated circuit chips, whose wired surfaces are arranged in a plane;

(b) binder material, of essentially the same material as the material of the chips, having essentially the same thermal expansion coefficient as the thermal expansion coefficient of the chips, filling the gaps between the chips, whereby the chips are bound together;

(c) an electrically insulating layer formed upon the wired surfaces of the chips and upon binder material in the filled gaps, excluding portions where terminal pads of the chips are located;

(d) electrically conductive layer-wiring formed upon the insulating layer for operatively connecting chip terminal pads;

(e) one or more device terminal pads for connecting the device to external circuitry, provided in connection with the electrically conductive layer-wiring.

According to the present invention, there is provided a method of fabricating a wafer-scale semiconductor integrated circuit device, comprising the steps of:-

(a) preparing integrated circuit chips, each with its wired surface covered with silicon nitride film;

(b) mounting a plurality of prepared chips on a surface of a substrate, each chip being mounted with its wired surface upwards;

(c) providing electrically insulating binder material, being essentially the same material as the material of the chips, whose thermal expansion coefficient is essentially the same as the thermal expansion coefficient of the chips, to fill gaps between the chips;

(d) removing excessive binder material, above and/or upon the chips, by polishing until said silicon nitride film on the chips is exposed;

(e) removing the silicon nitride film to expose the wired surfaces of the chips;

(f) coating the exposed surfaces of the chips, and binder material remaining in gaps between the chips, with an electrically insulating material, excluding areas where chip terminal pads are located; and

(g) patterning layer-wirings upon the insulating material, to interconnect the chip terminal pads and to provide and connect device terminal pads for connection of the device to external circuitry.

According to the present invention, there is provided a method of fabricating a wafer-scale semiconductor integrated circuit device, comprising the steps of:-

(a) preparing integrated circuit chips, each with its wired surface covered with silicon nitride film;

(b) mounting a plurality of prepared chips on a surface of a substrate, each chip being mounted with its film-covered wired surface in contact with a surface of the substrate;

(c) providing electrically insulating binder material, being essentially the same material as the material of the chips, whose thermal expansion coefficient is essentially the same as the thermal expansion coefficient of the chips, to fill gaps between the chips;

(d) removing the substrate by polishing until the silicon nitride film on the chips is exposed;

(e) removing the silicon nitride film to expose the wired surfaces of the chips;

(f) coating the exposed surface of the chips, and binder material remaining in gaps between the chips, with an electrically insulating material, excluding areas where chip terminal pads are located; and

(g) patterning layer-wirings upon the insulating material, to interconnect the chip terminal pads and to provide and connect device terminal pads for connection of the device to external circuitry.

According to an embodiment of the present invention, a plurality of IC chips having their layer-wired surfaces covered with silicon nitride film for chemical and physical protection are prepared. ("layer-wiring" or "layer-wired" is used here to mean an electrically conductive layer patterned on an electrically insulating layer or on an active element of an IC chip). A plurality of such IC chips are placed on a substrate, generally made of the same material as that of the IC chips, with the wired surfaces upwards.

The gaps between the IC chips are filled with a binder material. The binder material has essentially the same thermal expansion coefficient as the chips, and should be electrically insulating. The binder material is the same material as that of the IC chips. The binder material is provided by a crystal-growth method, so that the IC chips are bound to each other and to the substrate wafer by the binder material. Excessive binder material, grown higher than and/or upon the IC chips, is removed by polishing to expose the silicon nitride film.

The silicon nitride film is chemically removed until the layer-wirings of the IC chips are exposed. An electrically insulating layer is coated upon the exposed wired-surfaces of the IC chips as well as the surface of the binder material between the chips, excluding portions where terminal pads of the IC chips are located. Thereafter, aluminium interconnection layer-wirings are formed over the insulating layer to operatively connect the uncoated terminal pads of the IC chips and to provide input/output terminal pads for connection to external circuitry.

Reference is made, by way of example, to the accompanying drawings, in which:-

Figs. 1 to 7 schematically illustrate respective successive steps for fabricating a wafer-scale integrated device composed of multiple IC chips according to an embodiment of the present invention;

Fig. 7 further schematically illustrates in cross-section the structure of a finished wafer-scale integrated device according to an embodiment of the present invention;

Fig. 8 schematically illustrates the finished wafer-scale integrated device of Fig. 7 on a base plate; and

Figs. 9 and 10 schematically illustrate steps for fabricating a wafer-scale integrated device, employed as alternatives to the steps of Figs. 3 and 4, according to another embodiment of the present invention.

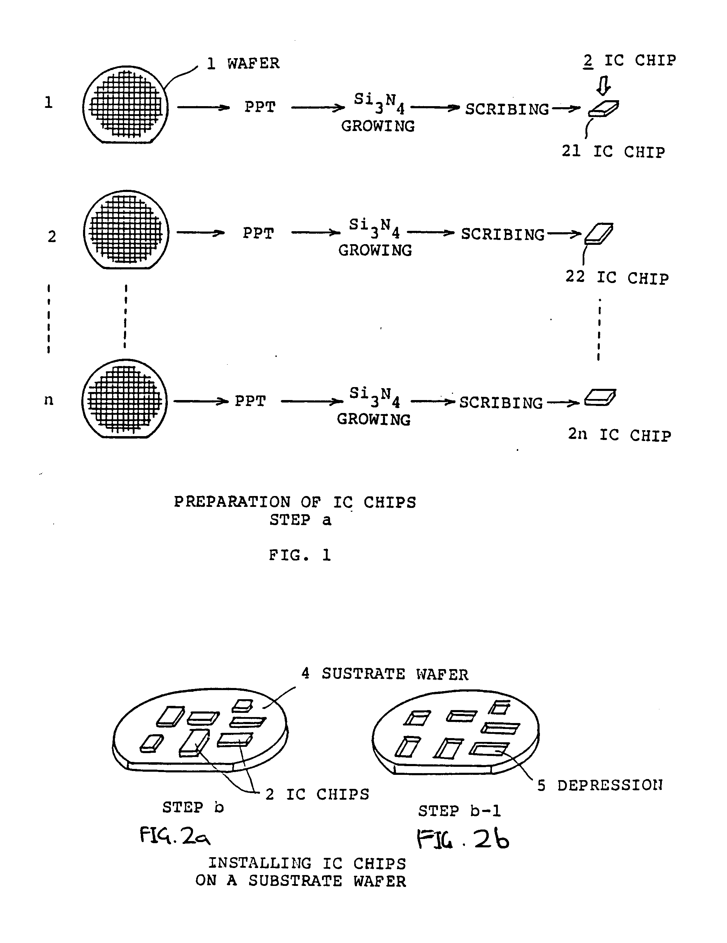

Examples of processes for fabricating wafer-scale integrated devices comprising multiple IC chips according to embodiments of the present invention are hereinafter described with reference to Figs. 1 to 8.

For preparing IC chips, as illustrated in Fig. 1, conventional IC wafers 1, 2 ... n (each numeral indicates that a different type of IC is involved) having electrically conductive layer-wirings thereon are tested with probes (referred to as PPT (Primary Probe Test)).

At the PPT stage, defective IC units on a wafer are marked to be rejected. For the electrically conductive material for layer-wiring on an IC, aluminium is generally used. Upon the surface with the layer-wirings of the chips of the wafer, there is formed a film of silicon nitride, $Si_3N_4$, a passivation film, by a method such as plasma CVD (Chemical Vapour Deposition), etc. During this process the temperature of the wafer is kept below 500°C so that the aluminium wiring does not melt or become an alloy. The thickness of the silicon nitride film is approximately 200 nm (2000 Angstroms). The purpose of providing this silicon nitride film is for protection of the aluminium layer-wiring from damage during subsequent mechanical and chemical polishing, which will be described below in some detail. This wafer coated with silicon nitride film is scribed into a plurality of individual IC chips. A set of IC chips, a combination of IC chips of either same or different IC types 21, 22 ... 2n necessary for constituting the required circuit in wafer-scale integration, is thus prepared.

In this embodiment of the present invention, a silicon wafer made of the same material as that of the IC chips is employed as a substrate wafer 4.

The prepared IC chips are placed on a surface of the substrate wafer 4, as shown in Fig. 2a, each chip with its silicon nitride covered surface upwards. On placing the IC chips, their locations are generally chosen in accordance with the principles that interconnections (which shall be described later) between the IC chips should be as short as possible and the frequency of crossings of interconnection wirings should be as low as possible.

For placing the IC chips tentatively or initially, an organic adhesive may be used.

However, as a rather preferable method, the substrate wafer 4 can be provided with depressions 5 formed thereon as shown in Fig. 2b. In this case each of the IC chips is placed in a respective corresponding depression. The depressions 5 are made by etching using a photo-lithography method, so that each IC chip can precisely and tightly sit in a respective depression. The depth(s) of the depressions is(are) chosen so that the top surfaces of the IC chips are higher (by one or several microns) than the surface of the substrate wafer 4 (the depth(s) also depend(s) upon the thickness of a (to be) grown silicon layer). If the thickness (height) of the IC chips is not uniform, the depth of each depression is chosen so that the wired surfaces of the chips all lie in a single plane, namely at a uniform height, when the chips are in place. Etching of different depths is carried out by selecting depressions in which additional etching is to be performed, to provide increased depth.

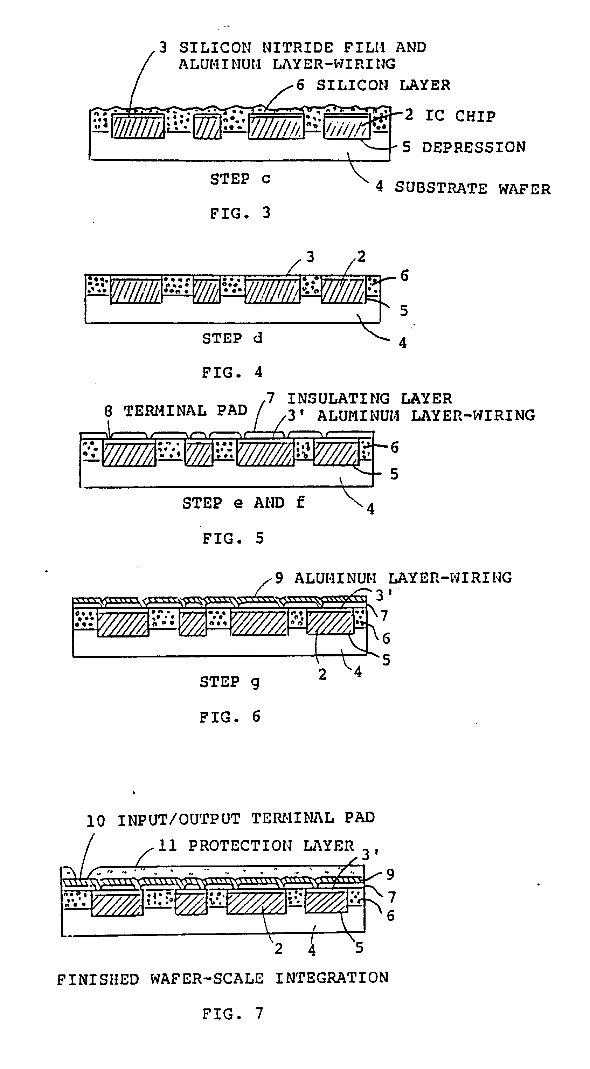

Next, the substrate wafer 4 together with the IC chips in the depressions 5 is processed for growing a silicon layer 6 thereover, as shown in Fig. 3. During this silicon-growing process also, the temperature of the IC chips is kept low enough to avoid undesirable effects on the aluminium wirings of the IC chips. Therefore, for growing the silicon layer, a CVD method which requires an IC temperature higher than 600°C for growing polycrystalline silicon cannot be employed. Consequently, as a method not requiring such a high temperature, low temperature CVD or sputtering by PVD (Physical Vapour Deposition) may be chosen. In the PVD method, a silicon target, as a cathode, is bombarded by argon ions, causing sputtering of silicon. Thus, by PVD, polycrystalline silicon or amorphous silicon is grown to form a layer of a thickness which may be several micrometres to several hundred micrometres, according to the height of the IC chips. The gaps between the IC chips are filled by the grown silicon, which binds with both the substrate wafer 4 and the scribed sides of the IC chips, to form a solid piece, because both the substrate and the IC chips are made of the same material as that of the binder, silicon. In other words, the substrate wafer and IC chips are incorporated into a single piece of solid wafer. Hereby, some silicon may be excessively grown, taller than and/or upon the silicon nitride layers 3 of the chips.

Next, the excess silicon, higher than or upon the silicon nitride 3, is removed by polishing until the silicon nitride 3 is fully exposed, as shown in Fig. 4. This polishing can be effected using a mechano-chemical method, which uses alumina powder as an abrasive material and a chemical etchant. While the excessive silicon is polished, the silicon nitride film protects the IC chips from mechanical and chemical damage, because the silicon nitride is mechanically harder than the polishing powder, the alumina powder, and chemically non-reactive with the etchant.

Next, the silicon nitride 3 is removed by conventional chemical etching (not shown in the Figure), because the function of the silicon nitride layer, protection, has been performed. Even after the removal of the nitride, the surface is essentially flat, because the thickness of the removed film is as little as 200 nm (2000 Angstroms). Thus, in Figs. 5 to 8, the region where the silicon nitride existed is not shown, namely ignored, and 3' indicates aluminium layer-wiring.

Next, an electrically insulating material is coated to form a layer 7 all over the polished surface. For this insulating material, conventional insulation film used for separating wiring-layers used in conventional wafer processing, such as silicon dioxide ($SiO_2$), silicon nitride ($Si_3N_4$), phospho-silicate glass (PSG) or polyimide can be employed. Next, the insulating layer 7, in particular portions where terminal pads 8 of the IC chips are located, is removed by conventional photo-lithography technology, as shown in Fig. 5. Thus, terminal pads 8 are exposed.

Next, an electrically conductive layer 9 is deposited upon the insulation layer 7 as well as the exposed terminal pads 8. For the electrically conductive material, aluminium is generally used. The deposited aluminium layer is patterned by photo-lithography technology to form interconnecting wiring. Thus, interconnections between the terminal pads 8 of the IC chips 2, as well as new input/output terminal pads 10 on the insulating layer 7, as terminals for electrical connection of the wafer-scale device to external circuitry, are fabricated at the same time.

A protection layer 11, made of PSG for example, may be formed upon the wired surface, excluding the input/output terminal pads 10, as shown in Fig. 7.

In the description given above of this embodiment of the present invention, the aluminium wiring 9 is a single wiring layer. However, two or more wiring layers, namely multi-layer wiring, can be used as in a conventional IC process, for crossing wirings. Multi-layer wirings according to this embodiment of the present invention can be produced much less expensively than in conventional multi-chip modules, because expensive multi-layer ceramics are not necessarily used. Multi-layer wiring according to an embodiment of the present invention can also be electrically less resistive than that of the previously used multi-layer wiring on ceramics, because an electrically good conductive material, such as aluminium, is used for wiring.

The locations of the IC chips are determined by the depressions made by lithography technology. Thus the positioning of the IC chips are so accurate that the distances between the aluminium wirings can be designed much finer, namely, the integration density can be elevated much higher than that of the previously proposed multi-chip module method using ICs encapsulated in chip carriers.

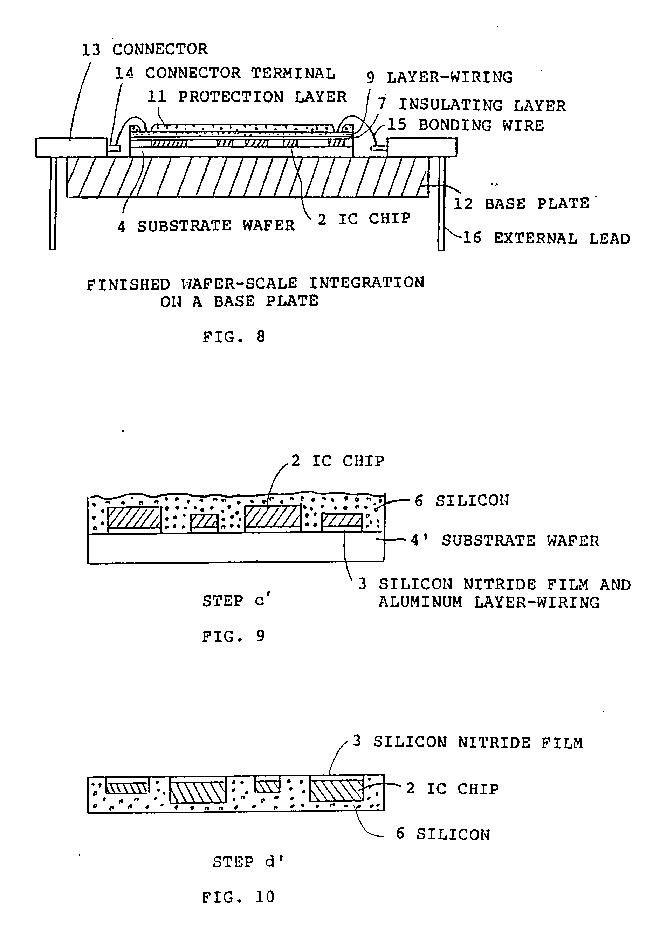

Now, according to an embodiment of the invention, a wafer made of a single piece which is equivalent to so-called wafer-scale integration is achieved. However, this wafer may be mechanically too fragile to be itself a practical device for use. The wafer, therefore, is reinforced by being mounted on a base plate 12 made of metal or ceramic, as shown in Fig. 8. This mounting is carried out by brazing or other conventional method, depending on design requirements. Generally, a very heat-conductive metal is used for the base plate, but heat conductive ceramics such as beryllia (BeO) or silicon carbide (SiC) etc. can also be used. Any preferred connecting means, such as bonding wires 15, conventional connector terminals 14 housed in a connector 13, and external leads 16, can be provided on the base plate 12, for convenience in later assembling processes using this device. Additionally, the wafer can be hermetically encapsulated by installing a cap (not shown in the Figure) over the base plate for mechanical and chemical protection and for heat conduction.

An alternative method according to an embodiment of the present invention for assembling the IC chips as a single big wafer is schematically illustrated in Figs. 9 and 10. Upon a flat surface of a big substrate wafer 4', IC chips 2 having silicon nitride surfaces thereon are placed keeping each silicon nitride surface 9 in contact with the surface of the wafer 4' in a step c' as shown in Fig. 9 in place of the former step c. Silicon is grown in the gaps between the chips 2 and upon the chips 2, by the same method as described above. The thickness of the silicon layer is chosen large enough to hold the chips, for example at least some hundreds of micrometres.

Next, the excessively grown silicon layer upon the chips is removed if necessary by mechano-chemical polishing, the same method as described above.

Next, the substrate wafer 4' is removed by the mechano-chemical polishing, until the silicon nitride surfaces of the IC chips are exposed, as shown by the step d' in Fig. 10, in place of the former step d. During this process, the silicon nitride film protects the chips from mechanical and chemical damage. Even after the removal of the substrate wafer 4', the IC chips are firmly bound to each other to form a single piece, equivalent to a real wafer-scale integration.

Next, successively, the silicon nitride surface films 3 are removed, an electrically insulating layer is formed over the IC chips, a polycrystalline silicon layer is formed thereon, aluminium layer-wirings are fabricated on the polycrystalline silicon layer, and the resulting structure is mounted on a base plate. The relevant fabrication methods corresponding to these respective processes are the same as those described above. An advantage of this method over the first method as illustrated in Figs. 3 and 4 is that it offers better flatness of the layer-wired IC surfaces, particularly when the thickness of the IC chips to be installed on the substrate wafer 4' is not uniform. Though in Figs. 9 and 10, the IC chips are placed on the surface of the substrate wafer 4', depressions having uniform depth can be provided in advance in the surface of the substrate wafer 4', by photo-lithography technology, for positioning the IC chips precisely.

Advantages of embodiments of the present invention can be summarized as follows:-

1. Prepared IC chips are all tested and defective chips rejected in advance: therefore the yield of wafer-scale integrated devices using combinations of these pretested IC chips is apparently high;

2. Freedom in designing a system is very large, because IC chips of different types are easily chosen out of ready-made types to constitute a required circuit;

3. Wirings between IC chips are fabricated upon a flat isolation layer by conventional IC technology, offering ease of provision of multi-layer wiring which results not only in greater design flexibility but also permits higher density wiring patterns, having a pitch as small as several tens of micrometres, and lower fabrication costs;

4. Conventional and existing production facilities for wafer-processing can be used for carrying into effect the present invention, thus no additional facilities are required;

5. A multi-layer ceramic substrate is not used. This contributes to reduction of material costs as well as to reduction of heat resistance for cooling the IC chips, because a silicon wafer has lower heat resistance than a ceramic wafer.

A device equivalent to a wafer-scale integration is achieved according to an embodiment of the present invention by employing multiple IC chips installed on a silicon wafer. For fabricating the device, conventional IC chips, if necessary of a variety of different types, are prepared, having their aluminium-wired surfaces coated with silicon nitride film. These IC chips are placed on a substrate made of silicon keeping the wired faces upwards. The wafer may be provided with depressions in which the chips are placed for precise positioning. Upon these chips and the wafer, a silicon layer is grown for example by a PVD method. The grown silicon layer fills gaps between the placed IC chips and binds the chips to each other and to the wafer, forming a single piece of wafer. Excessively grown silicon taller than and/or upon the chips is removed by mechano-chemical polishing until the silicon nitride surfaces are exposed. During this polishing process, the silicon nitride film protects the wired surfaces from mechanical and chemical damage. The silicon nitride film is chemically removed until the aluminium wirings are exposed. An insulating layer and aluminium patterning is formed upon the exposed IC chips and filled gaps to form for example multi-layer wirings for interconnection of the chips and for input/output connections. This allows wafer-scale integration of low cost fabrication, higher density wirings and good heat-removal.

An embodiment of the present invention provides a method of fabricating a wafer-scale integrated circuit device in which a plurality of IC chips, each prepared with a protective film over its wired surface, are placed on a substrate, binder material is grown to fill gaps between the chips and to bind chips together on the substrate. The protective film on the chips is then exposed, either by removing excess binder material or by removing (all or substantially all-depending on whether or not the chips are located in depressions in the substrate) the substrate (depending on whether the wired surfaces of the chips are initially placed downwards on the substrate, or upwards away from the substrate). The protective film is then removed to expose the wired surfaces of the chips. Wiring patterning is then formed to interconnect the chips and to provide for connection of the device to external circuitry.

## Claims

1. A wafer-scale semiconductor integrated circuit device, comprising:-
   (a) a plurality of integrated circuit chips (2);
   (b) a substrate (4) on which the chips are mounted, each with its wired surface upwards;
   (c) binder material (6), of essentially the same material as the material of the chips, having essentially the same thermal expansion coefficient as the thermal expansion coefficient of the chips, filling the gaps between the chips, whereby the chips are bound to the substrate and to each other;
   (d) an electrically insulating layer (7) formed upon the wired surfaces of the chips and upon the binder material in the filled gaps, excluding portions where terminal pads of the chips are located;
   (e) electrically conductive layer-wiring (9) formed upon the insulating layer (7) for operatively interconnecting the chip terminal pads (8); and
   (f) one or more device terminal pads (10), for connecting the device to external circuitry, provided in connection with the electrically conductive layer-wiring (9).

2. A wafer-scale semiconductor integrated circuit device comprising:-
   (a) a plurality of integrated circuit chips (2), whose wired surfaces are arranged in a plane;
   (b) binder material (6), of essentially the same material as the material of the chips, having essentially the same thermal expansion coefficient as the thermal expansion coefficient of the chips, filling the gaps between the chips, whereby the chips are bound together;
   (c) an electrically insulating layer (7) formed upon the wired surfaces of the chips and upon binder material in the filled gaps, excluding portions where terminal pads of the chips are located;
   (d) electrically conductive layer-wiring (9) formed upon the insulating layer (7) for operatively connecting chip terminal pads (8);
   (e) one or more device terminal pads (10) for connecting the device to external circuitry, provided in connection with the electrically conductive layer-wiring (9).

3. A device as claimed in claim 1 or 2, wherein the binder material (6) is of grown polycrystalline silicon.

4. A device as claimed in claim 1 or 2, wherein the binder material (6) is of grown amorphous silicon.

5. A device as claimed in any preceding claim, wherein the electrically conductive layer-wiring (9) has a multi-layer wiring structure, in which electrically conductive wiring layers are separated by electrically insulating layer material.

6. A device as claimed in any preceding claim, mounted on a surface of a base plate (12) with which surface a bottom surface of the device is fully in contact, whereby the device is mechanically held and heat dissipated in the device can be removed by conduction through the base plate.

7. A device as claimed in claim 1 or any one of claims 3 to 6 read as dependent upon claim 1, wherein the substrate has depressions (5) in which the chips are located.

8. A method of fabricating a wafer-scale semiconductor integrated circuit device, comprising the steps of:-
   (a) preparing integrated circuit chips (2), each with its wired surface covered with silicon nitride film;
   (b) mounting a plurality of prepared chips on a surface of a substrate (4), each chip being mounted with its wired surface upwards;
   (c) providing electrically insulating binder material (6), being essentially the same material as the material of the chips, whose thermal expansion coefficient is essentially the same as the thermal expansion coefficient of the chips, to fill gaps between the chips;
   (d) removing excessive binder material (6), above and/or upon the chips, by polishing until said silicon nitride film on the chips is exposed;
   (e) removing the silicon nitride film (3) to expose the wired surfaces of the chips;
   (f) coating the exposed surfaces of the chips, and binder material remaining in gaps between the chips, with an electrically insulating material (7), excluding areas where chip terminal pads (8) are located; and

(g) patterning layer-wirings (9) upon the insulating material (7), to interconnect the chip terminal pads (8) and to provide and connect device terminal pads (10) for connection of the device to external circuitry.

9. A method of fabricating a wafer-scale semiconductor integrated circuit device, comprising the steps of:-

(a) preparing integrated circuit chips (2), each with its wired surface covered with silicon nitride film (3);

(b) mounting a plurality of prepared chips on a surface of a substrate (4'), each chip being mounted with its film-covered wired surface (3) in contact with a surface of the substrate (4');

(c) providing electrically insulating binder material (6), being essentially the same material as the material of the chips, whose thermal expansion coefficient is essentially the same as the thermal expansion coefficient of the chips, to fill gaps between the chips;

(d) removing the substrate (4') by polishing until the silicon nitride film (3) on the chips is exposed;

(e) removing the silicon nitride film (3) to expose the wired surfaces of the chips;

(f) coating the exposed surface of the chips, and binder material remaining in gaps between the chips, with an electrically insulating material (7), excluding areas where chip terminal pads (8) are located; and

(g) patterning layer-wirings (9) upon the insulating material (7), to interconnect the chip terminal pads (8) and to provide and connect device terminal pads (10) for connection of the device to external circuitry.

10. A method as claimed in claim 8 or 9, wherein step (b) comprises:-

(i) etching the substrate in regions where chips are to be mounted, to a predetermined depth or to predetermined depths, by photo-lithography, whereby the said substrate surface is provided with depressions (5); and

(ii) placing chips (2) into corresponding depressions (5).

11. A method as claimed in claim 8, 9 or 10, wherein step (c) is accomplished by growing silicon to fill gaps between the chips.

12. A method as claimed in claim 11, wherein the silicon growing is effected by a sputtering method employing a silicon cathode onto which positive ions are bombarded.

13. A method as claimed in claim 11, wherein the silicon growing is effected by a chemical vapour deposition method.

14. A method as claimed in claim 9 or any one of claims 10 to 13 read as dependent upon claim 9, additionally comprising, after step (c), the step of:-

removing excessive binder material provided in step (c), by polishing.

15. A method as claimed in any one of claims 8 to 14, additionally comprising, between steps (f) and (g) one or more cycles of the following steps:-

patterning layer-wirings upon coated electrically insulating material as well as chip terminal pads, whereby the chip terminal pads are operatively interconnected and a device terminal pad is fabricated; and

coating the resulting surface with an electrically insulating material, excluding portions where chip and device terminal pads are located.

**Revendications**

1. Dispositif à circuit semi-conducteur intégré à l'échelle de la tranche, comprenant :

(a) une pluralité de puces de circuits intégrés (2) ;

(b) un substrat (4) sur lequel les puces sont montées, chacune avec sa surface câblée tournée vers le haut ;

(c) un matériau de liaison (6) essentiellement de même matériau que le matériau des puces, ayant essentiellement le même coefficient de dilatation thermique que le coefficient de dilatation thermique des puces, comblant les espaces entre les puces, par lequel les puces sont liées au substrat et entre elles ;

(d) une couche isolante électriquement (7) formée sur les surfaces câblées des puces et sur le matériau de liaison dans les espaces comblés, à l'exclusion des parties où sont situés des plots de connexion des puces ;

(e) un câblage en couche conducteur électriquement (9) formé sur la couche isolante (7) pour interconnecter fonctionnellement les plots de connexion de puces (8) ; et

(f) un ou plusieurs plots de connexion (10) du dispositif pour raccorder le dispositif à des circuits externes, obtenus en liaison avec le câblage en couche électriquement conducteur (9).

2. Dispositif à circuit semi-conducteur intégré à l'échelle de la tranche comprenant :

(a) une pluralité de puces de circuits intégrés (2), dont les surfaces câblées sont disposées dans un plan ;

(b) un matériau de liaison (6) essentiellement de même matériau que le matériau des puces, ayant essentiellement le même coefficient de dilatation thermique que le coefficient de dilatation thermique des puces, comblant les espaces entre les puces, par lequel les puces sont liées ensemble ;

(c) une couche isolante électriquement (7) formée sur les surfaces câblées des puces et sur le matériau de liaison dans les espaces comblés, à l'exclusion des parties où sont situés des plots de connexion des puces ;

(d) un câblage en couche électriquement conducteur (9) formé sur la couche isolante (7) pour connecter fonctionnellement les plots de connexion de puces (8) ;

(e) un ou plusieurs plots de connexion (10) du dispositif pour raccorder le dispositif à des circuits externes, obtenus en liaison avec le câblage en couche électriquement conducteur (9).

3. Dispositif selon la revendication 1 ou 2, dans lequel le matériau de liaison (6) est un dépôt de silicium polycristallin.

4. Dispositif selon la revendication 1 ou 2, dans lequel le matériau de liaison (6) est un dépôt de silicium amorphe.

5. Dispositif selon l'une quelconque des précédentes revendications, dans lequel le câblage en couche électriquement conducteur (9) a une structure de câblage multicouches, dans lequel les couches de câblage électriquement conductrices sont séparées par une couche de matériau isolant électriquement.

6. Dispositif selon l'une quelconque des précédentes revendications, monté sur la surface d'une base plane (12) avec laquelle surface une surface de base du dispositif est totalement en contact, de sorte que le dispositif est tenu mécaniquement et la chaleur dissipée dans le dispositif peut être évacuée par conduction à travers la base plane.

7. Dispositif selon la revendication 1 ou l'une quelconque des revendications 3 à 6 entendues comme dépendantes de la revendication 1, dans lequel le substrat comporte des dépressions (5) dans lesquelles les puces sont placées.

8. Procédé de fabrication d'un dispositif semiconducteur à circuit intégré à l'échelle de la tranche, comprenant les étapes de :

(a) préparation de puces de circuits intégrés (2), chacune ayant sa surface câblée recouverte d'un film de nitrure de silicium ;

(b) montage d'une pluralité de puces préparées sur une surface d'un substrat (4), chaque puce étant montée avec sa surface câblée tournée vers le haut ;

(c) apport d'un matériau de liaison isolant électriquement (6) essentiellement de même matériau que le matériau des puces, dont le coefficient de dilatation thermique est essentiellement le même que le coefficient de dilatation thermique des puces, pour combler les espaces entre les puces ;

(d) enlèvement de l'excès de matériau de liaison (6), au-dessus et/ou sur les puces, par polissage jusqu'à ce que ledit film de nitrure de silicium sur les puces soit mis à nu ;

(e) enlèvement de la couche de nitrure de silicium (3) pour mettre à nu les surfaces câblées des puces ;

(f) couverture des surfaces exposées des puces et du matériau de liaison restant dans les espaces entre les puces, par un matériau isolant électriquement (7), à l'exclusion des zones où sont situés des plots de connexion de puces (8) ; et

(g) formation de câblages en couche (9) sur le matériau isolant (7), pour interconnecter les plots de connexion de puces (8) et pour fournir et raccorder des plots de connexion du dispositif (10) pour raccordement du dispositif à des circuits externes.

9. Procédé de fabrication d'un dispositif semiconducteur à circuit intégré à l'échelle de la tranche, comprenant les étapes de :

(a) préparation de puces de circuits intégrés (2), chacune avec sa surface câblée recouverte d'un film de nitrure de silicium (3) ;

(b) montage d'une pluralité de puces préparées sur une surface d'un substrat (4'), chaque puce étant montée avec sa surface câblée recouverte par la couche (3) en contact avec une surface du substrat (4') ;

(c) apport d'un matériau de liaison isolant électriquement (6) essentiellement de même matériau que le matériau des puces, dont le coefficient de dilatation thermique est essentiellement le même que le coefficient de dilatation thermique des puces, pour combler les espaces entre les puces ;

(d) enlèvement du substrat (4') par polissage jusqu'à mise à nu du film de nitrure de silicium (3) sur les puces ;

(e) enlèvement du film de nitrure de silicium (3) pour mettre à nu les surfaces câblées des puces ;

(f) recouvrement de la surface exposée des puces, et du matériau de liaison restant dans les espaces entre les puces, par un matériau isolant électriquement (7), à l'exclusion des zones où sont situés des plots de connexion de puces (8) ; et

(g) formation de motifs de câblages en couche (9) sur le matériau isolant (7), pour interconnecter les plots de connexion de puces (8), et pour fournir et raccorder des plots de connexion du dispositif (10) pour connexion du dispositif à des circuits externes.

10. Procédé selon la revendication 8 ou la revendication 9, dans lequel l'étape (b) comprend :

(i) la gravure du substrat dans des régions où les puces doivent être montées, à une profondeur prédéterminée ou à des profondeurs prédéterminées, par photolithographie, de sorte que la surface dudit substrat présente des dépressions (5) ; et

(ii) placement des puces (2) dans des dépressions (5) correspondantes.

11. Procédé selon les revendications 8, 9 ou 10, dans lequel l'étape (c) est obtenue par croissance de silicium pour combler les espaces entre les puces.

12. Procédé selon la revendication 11, dans lequel la croissance du silicium est effectuée par un procédé de pulvérisation employant une cathode en silicium bombardée par des ions positifs.

13. Procédé selon la revendication 11, dans lequel la croissance du silicium est effectuée par un procédé de dépôt chimique en phase vapeur.

14. Procédé selon la revendication 9 ou l'une quelconque des revendications 10 à 13 entendues comme dépendantes de la revendication 9, comprenant en outre, après l'étape (c), l'étape de :

enlèvement par polissage du matériau de liaison en excès fourni par l'étape (c).

15. Procédé selon l'une quelconque des revendications 8 à 14, comprenant en outre, entre les étapes (f) et (g) un ou plusieurs cycles des étapes suivantes :

formation de motifs de câblage en couche sur un revêtement de matériau isolant électriquement comme sur des plots de connexion de puces, de sorte que les plots de connexion de puces sont interconnectés fonctionnellement et un plot de connexion du dispositif est fabriqué ; et

revêtement de la surface résultante avec un matériau isolant électriquement, à l'exclusion de parties où des plots de connexion de puce ou de dispositif sont situés.

**Patentansprüche**

1. Waferintegrierte Halbleiteranordnung mit:-

(a) einer Vielzahl von integrierten Schaltungschips (2):

(b) einem Substrat (4), auf welchem die Chips montiert sind, jedes mit seiner verdrahteten Oberfläche nach oben;

(c) Bindermaterial (6) aus im wesentlichen demselben Material wie das Material der Chips, welches im wesentlichen denselben thermischen Expansionskoeffizienten wie der thermische Expansionskoeffizient der Chips hat, Füllen der Lücken zwischen den Chips, wodurch die Chips in dem Substrat und miteinander verbunden werden;

(d) einer elektrischen Isolierschicht (7), die auf den verdrahteten Oberflächen der Chips und auf dem Bindermaterial in den gefüllten Lücken gebildet ist, ausschließlich der Abschnitte, wo die Anschlußpads der Chips angeordnet sind;

(e) elektrisch leitender Verdrahtungsschicht (9), die auf der Isolationsschicht (7) gebildet ist, um wirkungsmäßig die Chipanschlußpads (8) untereinander zu verbinden;

(f) einer oder mehreren Anordnungsanschlußpads (10), um die Anordnung mit einer externen Schaltung zu verbinden, die in Verbindung mit der elektrischen Verdrahtungschicht (9) vorgesehen sind.

2. Waferintegrierte Halbleiterschaltungsanordnung mit:-

(a) einer Vielzahl von integrierten Schaltungschips (2), deren verdrahtete Oberflächen in einer Ebene angeordnet sind;

(b) Bindermaterial (6) aus im wesentlichen demselben Material wie das Material der Chips, welches im wesentlichen denselben thermischen Expansionskoeffizienten wie der thermische Expansionskoeffizient der Chips hat, Füllen der Lücken zwischen den Chips, wobei die Chips miteinander verbunden werden;

(c) einer elektrischen Isolationsschicht (7), die auf den verdrahteten Oberflächen der Chips und auf dem Bindermaterial in den gefüllten Lücken gebildet ist, ausschließlich von Abschnitten, wo die Anschlußpads der Chips angeordnet sind;

(d) elektrisch leitender Schichtverdrahtung (9), die auf der Isolationsschicht (7) gebildet ist, um die Chipanschlußpads (8) wirkungsmäßig miteinander zu verbinden;

(e) einem oder mehreren Anschlußpads (10), zum Verbinden der Anordnung mit einer externen Schaltung, die in Verbindung mit der elektrisch leitenden Schichtverdrahtung (9) vorgesehen sind.

3. Anordnung nach Anspruch 1 oder 2, bei der das Bindermaterial (6) aus gewachsenem polykristallinem Silizium besteht.

4. Anordnung nach Anspruch 1 oder 2, bei der das Bindermaterial (6) aus gewachsenem amorphem Silizium besteht.

5. Anordnung nach einem der vorhergehenden Ansprüche, bei der die elektrisch leitende Schichtverdrahtung (9) eine Mehrfachschichtverdrahtungsstruktur hat, bei der elektrisch leitende Verdrahtungsschichten durch elektrisch isolierendes Schichtmaterial getrennt sind.

6. Anordnung nach einem der vorhergehenden Ansprüche, montiert auf der Oberfläche einer Basisplatte (12), mit welcher Oberfläche eine untere Oberfläche der Anordnung in vollem Kontakt ist, wodurch die Anordnung mechanisch gehalten wird und Hitze, die in der Anordnung abgegeben wird, durch Leitung durch die Basisplatte entfernt werden kann.

7. Anordnung nach Anspruch 1 oder einem der Ansprüche 3 bis 6 in Verbindung mit Anspruch 1, bei der das Substrat Eindrücke (5) hat, in denen die Chips angeordnet sind.

8. Verfahren zur Herstellung einer waferintegrierten Halbleiterschaltungsanordnung mit den folgenden Schritten:-

(a) Herstellen von integrierten Schaltungschips (2), jedes mit seiner verdrahteten Oberfläche mit einem Sliziumnitridfilm bedeckt;

(b) Montieren einer Vielzahl von präparierten Chips auf einer Oberfläche eines Substrats (4), wobei jedes Chip mit seiner verdrahteten Oberfläche nach oben montiert wird;

(c) Bereitstellen von elektrisch isolierendem Bindermaterial (6), welches im wesentlichen aus demselben Material wie das Material der Chips besteht, dessen thermischer Expansionskoeffizient im wesentlichen derselbe wie der thermische Expansionskoeffizient der Chips ist, um die Lücken zwischen den Chips zu füllen;

(d) Entfernen überschüssigen Bindermaterials (6), oberhalb und/oder auf den Chips, durch Polieren, bis der genannte Siliziumnitridfilm auf den Chips freigelegt ist;

(e) Entfernen des Siliziumnitridfilms (3), um die verdrahteten Oberflächen der Chips freizulegen;

(f) Bedecken der freigelegten Oberflächen der Chips und von Bindermaterial, welches in den Lücken zwischen den Chips verbleibt, mit einem elektrisch isolierenden Material (7), mit Ausnahme der Bereiche, wo die Chipanschlußpads (8) angeordnet sind;

(g) Mustern von Schichtverdrahtungen (9) auf dem isolierenden Material (7), um die Chipanschlußpads (8) untereinander zu verbinden und um Anordnungsanschlußpads (10) vorzusehen und zu verbinden, zur Verbindung der Anordnung mit einer äußeren Schaltung.

9. Verfahren zur Herstellung einer waferintegrierten Halbleiterschaltungsanordnung, mit den folgenden Schritten:-

(a) Präparieren integrierter Schaltungschips (2), jeweils mit ihrer verdrahteten Oberfläche mit einem Siliziunnitridfilm (3) bedeckt;

(b) Montieren einer Vielzahl von präparierten Chips auf der Oberfläche eines Substrats (4'), wobei jedes Chip mit seiner filmbedeckten verdrahteten Oberfläche (3) mit einer Oberfläche des Substrats (4') in Kontakt ist;

(c) Bereitstellen elektrisch isolierenden Bindermaterials (6), welches im wesentlichen dasselbe Material wie das Material der Chips ist, dessen thermischer Expansionskoeffizient im wesentlichen derselbe wie der thermische Expansionskoeffizient der Chips ist, um Lücken zwischen den Chips zu füllen;

(d) Entfernen des Substrats (4') durch Polieren bis der Siliziumnitridfilm (3) auf den Chips freigelegt ist;

(e) Entfernen des Siliziumnitridfilms (3), um die verdrahteten Oberflächen der Chips freizulegen;

(f) Bedecken der exponierten Oberfläche der Chips und des in Lücken zwischen den Chips verbleibenden Bindermaterials mit einem elektrisch isolierenden Material (7), mit Ausnahme der Bereiche, wo die Chipanschlußpads (8) angeordnet sind;

(g) Mustern von Schichtverdrahtungen (9) auf dem isolierenden Material (7), um die Chipanschlußpads (8) untereinander zu verbinden, und um Anordnungsanschlußpads (10) vorzusehen und zu verbinden, zur Verbindung der Anordnung mit einer äußeren Schaltung.

10. Verfahren nach Anspruch 8 oder 9, bei dem der Schritt (b) umfaßt:-

(i) Ätzen des Substrats in Bereichen, wo Chips montiert werden sollen, zu einer vorbestimmten Tiefe oder zu vorbestimmten Tiefen, durch Fotolithographie, wodurch die genannte Substratoberfläche mit Vertiefungen (5) versehen wird;

(ii) Plazieren der Chips (2) in entsprechende Vertiefungen (5).

11. Verfahren nach Anspruch 8, 9 oder 10, bei dem der Schritt (c) durch Wachsen von Silizium zum Füllen der Lücken zwischen den Chips erreicht wird.

12. Verfahren nach Anspruch 11, bei dem das Aufwachsen von Silizium durch ein Zerstäubungsverfahren bewirkt wird unter Verwendung einer Siliziumkathode, auf welche positive Ionen bombardiert werden.

13. Verfahren nach Anspruch 11, bei dem das Aufwachsen des Siliziums durch ein chemisches Dampfabscheidungsverfahren bewirkt wird.

14. Verfahren nach Anspruch 9 oder einen der Ansprüche 10 bis 13 in Verbindung mit Anspruch 9, welches, nach dem Schritt (c), zusätzlich umfaßt :-

Entfernen überschüssigen Bindermaterials, welches bei dem Schritt (c) bereitgestellt wird, durch Polieren.

15. Verfahren nach einem der Ansprüche 8 bis 14, welches zusätzlich zwischen den Schritten (f) und (g), einen oder mehrere Zyklen der folgenden Schritte umfaßt:-

Mustern von Schichtverdrahtungen auf überzogenem elektrisch isolierendem Material sowie Chipanschlußpads, wodurch die Chipanschlußpads wirkungsmäßig untereinander verbunden werden und ein Anordnungsanschlußpad hergestellt wird;

Überziehen der resultierenden Oberfläche mit einem elektrisch isolierenden Material, mit Ausnahme der Abschnitte, wo die Chip- und Anordnungsanschlußpads angeordnet sind.

1 WAFER

2 IC CHIP

1 → PPT → Si₃N₄ GROWING → SCRIBING → 21 IC CHIP

2 → PPT → Si₃N₄ GROWING → SCRIBING → 22 IC CHIP

n → PPT → Si₃N₄ GROWING → SCRIBING → 2n IC CHIP

PREPARATION OF IC CHIPS
STEP a

FIG. 1

4 SUSTRATE WAFER

2 IC CHIPS

5 DEPRESSION

STEP b

FIG. 2a

STEP b-1

FIG. 2b

INSTALLING IC CHIPS
ON A SUBSTRATE WAFER

3 SILICON NITRIDE FILM AND ALUMINUM LAYER-WIRING
6 SILICON LAYER
2 IC CHIP
5 DEPRESSION
4 SUBSTRATE WAFER

STEP c

FIG. 3

STEP d

FIG. 4

8 TERMINAL PAD
7 INSULATING LAYER
3' ALUMINUM LAYER-WIRING

STEP e AND f

FIG. 5

9 ALUMINUM LAYER-WIRING

STEP g

FIG. 6

10 INPUT/OUTPUT TERMINAL PAD
11 PROTECTION LAYER

FINISHED WAFER-SCALE INTEGRATION

FIG. 7

13 CONNECTOR
14 CONNECTOR TERMINAL
11 PROTECTION LAYER
9 LAYER-WIRING
7 INSULATING LAYER
15 BONDING WIRE
4 SUBSTRATE WAFER
2 IC CHIP
12 BASE PLATE
16 EXTERNAL LEAD

FINISHED WAFER-SCALE INTEGRATION
ON A BASE PLATE

FIG. 8

2 IC CHIP
6 SILICON
4' SUBSTRATE WAFER
3 SILICON NITRIDE FILM AND
ALUMINUM LAYER-WIRING

STEP c'

FIG. 9

3 SILICON NITRIDE FILM
2 IC CHIP
6 SILICON

STEP d'

FIG. 10